# EUROPÄISCHE PATENTSCHRIFT

(11) **EP 2 671 262 B1**
(45) Veröffentlichungstag und Bekanntmachung des Hinweises auf die Patenterteilung: **12.09.2018**
(21) Anmeldenummer: 12714556.3
(22) Anmeldetag: 31.01.2012
(51) Int. Cl.: H01L 31/048, H01L 31/054

(54) **Solarzellenempfänger**
SOLAR CELL RECEIVER
RÉCEPTEUR DE CELLULE SOLAIRE

(30) Priorität: 31.01.2011 EP 11000736
(43) Veröffentlichungstag der Anmeldung: 11.12.2013
(73) Patentinhaber: AZUR SPACE Solar Power GmbH, 74072 Heilbronn (DE)
(72) Erfinder: SCHILLING, Roland, 75050 Gemmingen (DE); KHORENKO, Victor, 74196 Neuenstadt a. K. (DE)
(74) Vertreter: Koch Müller Patentanwaltsgesellschaft mbH
(86) Internationale Anmeldenummer: PCT/EP2012/000704
(87) Internationale Veröffentlichungsnummer: WO 2012/104107

(56) Entgegenhaltungen:
- EP-A1- 1 953 835
- EP-A1- 2 073 279
- EP-A1- 2 194 584
- EP-A1- 2 278 630
- EP-A1- 2 278 631
- CN-A- 101 436 619
- US-A- 5 167 724
- US-A1- 2007 070 531
- US-A1- 2007 102 722
- US-A1- 2011 017 295

## Beschreibung

Die Erfindung betrifft ein Solarzellenempfänger gemäß dem Oberbegriff des Patentanspruchs 1.

Aus der EP 2 073 279 A1 ist ein Solarzellenempfänger bekannt, bei dem ein als Solarzelle ausgebildeter Halbleiterkörper auf einem Träger angeordnet ist. Um den Halbleiterkörper und insbesondere dessen Seitenflächen vor Umgebungseinflüssen zu schützen, die zu einer Degradation der elektrischen Parameter führen, wird um den Halbleiterkörper an drei Seiten ein Rahmen angeordnet und mit einem transparenten Deckel abgeschlossen. Anschließend wird der verbleibende Zwischenraum mit einer transparenten Vergussmasse aufgefüllt und ein optisches Element angebracht.

Aus der EP 1 953 825 A2 ist ein Gehäuse bekannt, bei dem auf einem Träger ein als LED ausgebildeter Halbleiterkörper angeordnet ist. Anschließend wird zum Schutz des Halbleiterkörpers eine Dichtfolie und ein aus mehreren Teilen bestehendes Gehäuse, welches auch ein optisches Element umfasst, in einem mehrstufigen Prozess auf dem Träger angeordnet.

Aus der US 2011 0172 95 A1 ist eine Solarzelle mit einem optischen Element bekannt. Das optische Element bündelt das einfallende Licht auf die Solarzelle und ist gleichzeitig die Vergussmasse für die Solarzelle. Die Vergussmasse umschließt die Halbleiterschichten der Solarzelle fast vollständig. Des Weiteren ist aus der EP 2 278 631 A1 ein weiterer Aufbau einer Solarzelle mit einem optischen Element bekannt. Aus der US 2007 102 722 A1, der EP 1 953 835 A1, der EP 2 073 279 A1 und der EP 2 194 584 A1 sind eine Vielzahl von Gehäuseausführungen mit einem optischen Element und einer LED bekannt. Aus der US 5 167 724 A ist eine Solarzelle mit einem optischen Element bekannt, wobei das optische Element aus einer Quarzglasverbindung besteht. Vor diesem Hintergrund besteht die Aufgabe der Erfindung darin, eine Vorrichtung anzugeben, die den Stand der Technik weiterbildet.

Die Aufgabe wird durch ein Solarzellenempfänger mit den Merkmalen des Patentanspruchs 1 gelöst. Vorteilhafte Ausgestaltungen der Erfindung sind Gegenstand von Unteransprüchen.

Gemäß dem Gegenstand der Erfindung wird ein Solarzellenempfänger mit einem Halbleiterkörper offenbart, aufweisend eine Vorderseite mit einer auf der Vorderseite ausgebildeten Solarzelle und eine Rückseite und mehrere Seitenflächen und zwei elektrischen Anschlüssen, und einem Träger zur Aufnahme des Halbleiterkörpers, wobei die Rückseite des Halbleiterkörpers auf dem Träger fixiert ist, und einem optischen Element für eine Bündelung von Licht auf die Vorderseite des Halbleiterkörpers, aufweisend eine Unterseite, die der Oberseite des Halbleiterkörpers teilweise zugewandt ist, wobei das optische Element an der Unterseite eine erste Ausformung mit einer ersten Oberfläche aufweist, die auf der Vorderseite des Halbleiterkörpers aufliegt und eine zweite Oberfläche aufweist, die auf dem Träger aufliegt und die Ausformung als Kavität oder als Falz ausgebildet ist.

Ein Vorteil der erfindungsgemäßen Vorrichtung ist es, dass das optische Element, welches vorzugsweise als Konzentrator ausgebildet ist, eine der Form und Größe des Halbleiterkörpers angepasste Ausformung aufweist und durch Absenken des optischen Elements auf den Träger den als Solarzelle ausgebildeten Halbleiterkörper und insbesondere die Seitenränder des Halbleiterkörpers zuverlässig vor Umgebungseinflüssen schützt. Indem das optische Element zugleich auch Gehäuse ist, wird eine kostengünstige Lösung geschaffen, äußerst robuste Solarzellenempfänger herzustellen. Die Anzahl der Fertigungsschritte zur Herstellung des Solarzellenmoduls wird reduziert.

Untersuchungen der Anmelder haben gezeigt, dass sich unterschiedliche Formen von optischen Elementen als Gehäuse ausbilden lassen, welche die aus dem Träger herausstehenden Teile des Halbleiterkörpers allseitig umschließen. Hierbei ist es bevorzugt, die jeweiligen Formen des optischen Elements einstückig auszubilden. Bevorzugte Formen von optischen Elementen sind unter anderem eine linsenförmige oder trichterförmige oder pyramidenstumpfförmige Ausbildung. Gemeinsames Kennzeichen der unterschiedlichen Formen von den optischen Elementen ist es, dass jede Form an der Unterseite eine umlaufende Randfläche aufweist, welche im Wesentlichen formschlüssig mit der Oberfläche des Trägers abschließt. Es ist bevorzugt, dass die Kavität oder der Falz der ersten Ausformung des optischen Elements vollständig umlaufend um die Seitenflächen des Halbleiterkörpers ausgebildet sind. Bei der Ausführung mit einem Falz an der Unterseite des optischen Elements ist auf der Vorderseite des Halbleiterkörpers nur der äußere Randbereich mit einem Teil des Falzes des optischen Elements abgedeckt. Es ist bevorzugt in dem äußeren Randbereich des Halbleiterkörpers, der von dem Falz bedeckt wird, eine Dichtschicht, die vorzugsweise als transparente Klebstoffschicht ausgebildet ist, zwischen dem optischen Element und der Vorderseite des Halbleiterkörpers anzuordnen.

In einer Weiterbildung bildet die erste Ausformung zusammen mit den Seitenflächen des Halbleiterkörpers ein Zwischenraum aus. Es ist bevorzugt, den Zwischenraum mit einer transparenten Vergussmasse aufzufüllen. In einer alternativen Ausführungsform ist zwischen den Seitenflächen und der ersten Ausformung ein Dichtmittel vorgesehen. Bevorzugt lässt sich die Vergussmasse als transparentes Dichtmittel ausführen.

In einer anderen Ausführungsform ist es bevorzugt, zwischen der zweiten Oberfläche und dem Träger eine Klebstoffschicht, die vorzugsweise als transparente Schicht ausgebildet ist, angeordnet. Hierdurch lässt sich das optische Element fixieren. Des Weiteren bildet die Klebstoffschicht eine Dichtfläche zwischen dem optischen Element und Träger aus, so dass der Halbleiterkörper hermetisch gegenüber der Umgebung abgedichtet ist. In einer anderen Weiterbildung wird zusätzlich oder alternativ zwischen der ersten Oberfläche und der Vorderseite des Halbleiterkörpers eine Vergussmasse, die vorzugsweise als transparente Vergussmasse ausgebildet ist, angeordnet.

Gemäß einer Weiterbildung weist das optische Element eine zweite als Kavität ausgebildete Ausformung auf. Es ist bevorzugt, dass das optische Element in der zweiten Ausformung einen aus der Oberfläche des Trägers ausgebildeten Teil einer By-Pass-Diode aufnimmt. Hierbei ist die By-Pass-Diode beabstandet von dem Halbleiterkörper. In einer alternativen Ausführungsform ist es bevorzugt, dass die zweite Ausformung mit der ersten Ausformung eine Verbindung aufweist, derart dass nur eine einzige Ausformung ausgebildet wird, welche beide Bauteile aufnimmt. Hierdurch bildet sich nach dem Aufbringen des optischen Elements zwischen wenigstens einer Seitenfläche der Solarzelle und wenigstens einer Seitenfläche der By-Pass-Diode ein gemeinsamer Zwischenraum, der bevorzugt mit einer Vergussmasse aufgefüllt wird.

In einer bevorzugten Ausführungsform ist das optische Element als ein sekundäres optisches Element ausgebildet und konzentriert einen bereits gebündelten Lichtstrahl weiter. Mittels der mehrstufigen Bündelung lassen sich Konzentrationsfaktoren oberhalb 50, vorzugsweise oberhalb 100 und höchst vorzugsweise oberhalb 300 erreichen. Indem bereits mittels der ersten Bündlung durch eine hier nicht näher ausgeführte primäre Optik, die zumeist als eine Fresnel Linse ausgebildet ist, einen hohen Konzentrationsfaktor oberhalb 50 erzielt, trifft das so gebündelte Licht auf das optische Element.

Untersuchungen haben gezeigt, dass die Energie des gebündelten Lichtes für ein organisch ausgebildetes transparentes optisches Element zu hoch ist. Das organische Element wird aufgrund der hohen Temperaturen schnell irreversibel geschädigt und trübe. Gemäß einer Weiterbildung, besteht das optische Element aus einem anorganischen Material. Insbesondere ist das optische Element transparent für ultraviolettes Licht ausgebildet. Bevorzugt ist das optische Element aus einer Quarzglasverbindung gefertigt. Quarzglas ist sowohl für UV-Licht transparent, als auch besonders hitzebeständig und alterungsbeständig. Des Weiteren ist das Quarzglas sehr gut recyclingfähig.

Die Erfindung wird nachfolgend unter Bezugnahme auf die Zeichnungen näher erläutert. Hierbei werden gleichartige Teile mit identischen Bezeichnungen beschriftet. Die dargestellte Ausführungsformen sind stark schematisiert, d.h. die Abstände und laterale und vertikale Erstreckung sind nicht maßstäblich und weisen, sofern nicht anders angegeben auch keine ableitbare geometrische Relation zueinander auf. Darin zeigen die:
- Figur 1: eine schematischen Querschnitt auf eine erfindungsgemäße Ausführungsform eines Solarzellenempfängers mit einem optischen Element,
- Figur 2: einen schematischen Querschnitt auf ein Solarzellenempfänger mit einem optischen Element und einer By-Pass-Diode,
- Figur 3: einen schematischen Querschnitt auf ein Solarzellenempfänger mit einem pyramidenförmigen optischen Element mit einer By-Pass-Diode,
- Figur 4: einen schematischen Querschnitt auf ein Solarzellenempfänger mit einem trichterförmigen optischen Element mit einer By-Pass-Diode.

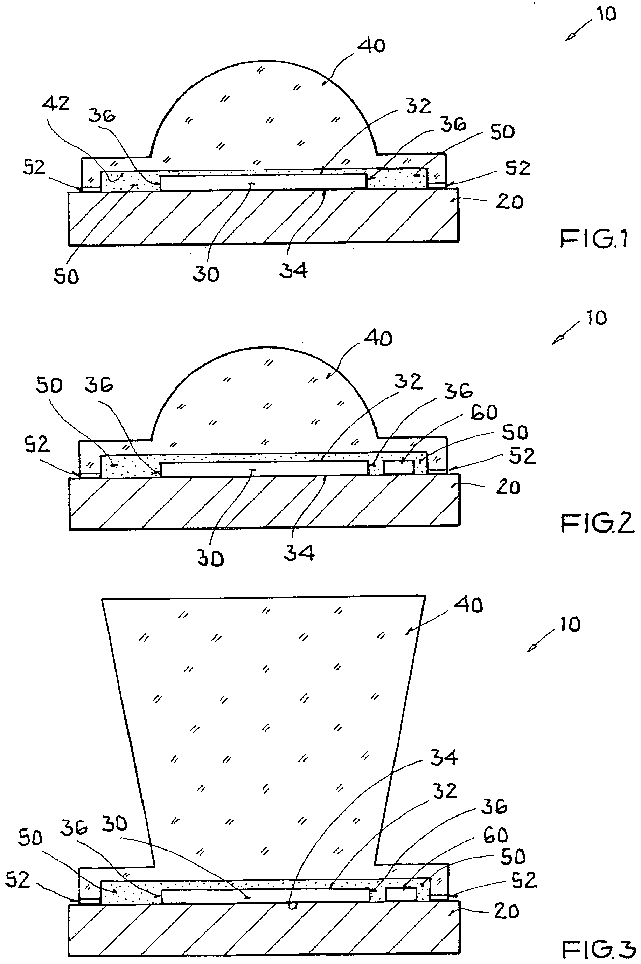

Die Abbildung der Figur 1 zeigt einen schematischen Querschnitt eines erfindungsgemäßen Solarzellenempfängers 10, aufweisend einen Träger 20, einen als Solarzelle ausgebildeten Halbleiterkörper 30 mit einer Vorderseite 32 und einer Rückseite 34 und mehreren Seitenfläche 36. Die Rückseite 34 des Halbleiterkörpers 30 ist auf dem Träger 20 fixiert. Oberhalb der Vorderseite 32 ist ein linsenförmiges optisches Element 40 ausgebildet, der eine Unterseite mit einer Kavität 42 zur Aufnahme des Halbleiterkörpers 30 ausbildet. Eine erste Oberfläche des optischen Elements 40 ist oberhalb der Vorderseite 32 des Halbleiterkörpers 30 ausgebildet. Das optische Element 40 liegt mit einer zweiten Oberfläche auf dem Träger 20 auf. Die Kavität 42 ist größer ausgebildet als der Halbleiterkörper 30. Der Raum zwischen dem optischen Element 40 und dem Halbleiterkörper 30 ist mit einer vorzugsweisen transparenten Vergussmasse 50 ausgefüllt. Ferner ist zwischen der zweiten Oberfläche und dem Träger 20 eine Klebstoffschicht 52 ausgebildet. Des Weiteren weist der Halbleiterkörper 30 wenigstens zwei elektrische Anschlüsse vorzugsweise auf der Vorderseite auf, welche nicht dargestellt sind. Es sei angemerkt, dass das optische Element 40 vorzugsweise einstückig ausgeführt ist und neben der Funktion der Bündelung von einfallendem Licht auf die Vorderseite des Halbleiterkörpers 30, eine dichtende Eigenschaft insbesondere in Zusammenhang mit der Vergussmasse 50 und der Klebstoffschicht 52 aufweist, d.h. den Halbleiterkörper 30 vor Umgebungsweinflüssen schützt. Die Bündelung von Licht wird mittels der linsenförmigen Ausbildung des optischen Elements 40 erzielt.

In der Abbildung der Figur 2 ist eine weitere Ausführungsform des Solarzellenempfängers 10 dargestellt. Nachfolgend werden nur die Unterschiede zu der Ausführungsform der Figur 1 erläutert. Auf dem Träger 20 ist eine By-Pass-Diode 60 beabstandet angeordnet. Die By-Pass-Diode 60 ist mit der Solarzelle verschaltet - nicht dargestellt. Die Größe der Kavität 42 umfasst die By-Pass-Diode 60.

Der Raum zwischen dem optischen Element 40 und der By-Pass-Diode 60 ist mit der Vergussmasse 50 ausgefüllt. Hierdurch ist die By-Pass-Diode 60 sowohl durch das optische Element 40 als auch von der Vergussmasse 50 in Verbindung mit der Klebstoffschicht 52 vor Umgebungseinflüssen geschützt.

In der Figur 3 ist ein schematischer Querschnitt eines Solarzellenempfängers dargestellt, bei dem das optische Element 40 eine pyramidenstumpfförmige Ausbildung aufweist. Die Kavität 42 an der Unterseite umfasst sowohl die Solarzelle als auch die By-Pass-Diode 60. Das auf das optische Element 40 einfallenden Licht wird vorzugsweise auf dem Wege der Totalreflektion auf die Vorderseite 32 des Halbleiterkörpers 30 geleitet.

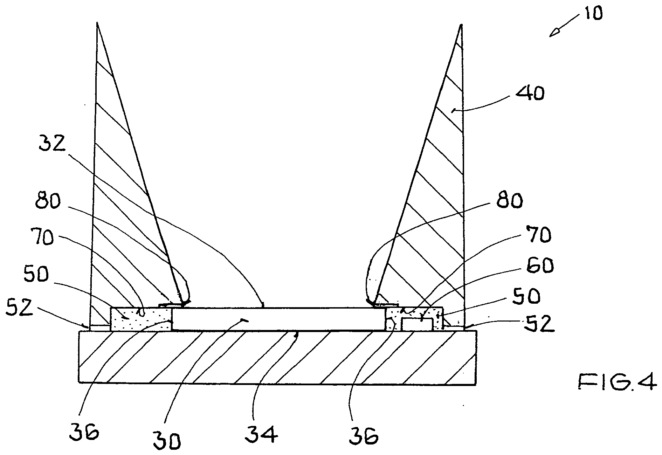

In der nicht zur Erfindung gehörenden Ausführungsform ist in der Figur 4 in einem schematischen Querschnitt eine trichterförmige Ausbildung des optischen Elements 40 dargestellt. An der Innenseite des Trichters wird das einfallende Licht auf dem Wege der spiegelnden Reflektion zur Vorderseite des Halbleiterkörpers 30 geleitet. Hierfür lässt sich die Innenseite des Trichters mit einer reflektierenden metallischen Schicht bedecken. An der Unterseite des optischen Elements 40 ist ein umlaufender Falz 70 ausgeformt. Die Vorderseite 32 des Halbleiterkörpers 30 ist im Bereich der Trichteröffnung weder von dem optischen Element 40 noch von der Vergussmasse 50 bedeckt. Demhingegen ist die Vorderseite 32 des Halbleiterkörpers 30 im Bereich des Randes von dem Falz 70 bedeckt. Vorzugsweise ist zwischen dem auf der Vorderseite 32 aufliegenden Teil des Falzes 70 und dem Halbleiterkörper 30 eine Dichtschicht 80 ausbildet. Der verbleibende Raum des Falzes 70 ist mit der Vergussmasse 50 ausgefüllt.

## Patentansprüche

1. Solarzellenempfänger (10) mit,
- einem Halbleiterkörper (30), aufweisend eine Vorderseite (32) mit einer auf der Vorderseite ausgebildeten Solarzelle und eine Rückseite (34) und mehrere Seitenfläche (36) und zwei elektrischen Anschlüssen,
- einem Träger (20) zur Aufnahme des Halbleiterkörpers, wobei die Rückseite (34) des Halbleiterkörpers (30) auf dem Träger (20) fixiert ist, und
- einem optischen Element (40) für eine Bündelung von Licht auf die Vorderseite (32) des Halbleiterkörpers (30), wobei das optische Element (40) einstückig ausgebildet ist
**dadurch gekennzeichnet, dass**
- der gesamte Träger (20) eine ebene Oberfläche aufweist,
- das optische Element eine Unterseite aufweist, die der Oberseite des Halbleiterkörpers (30) teilweise zugewandt ist,
- das optische Element (40) an der Unterseite eine erste Ausformung mit einer ersten Oberfläche aufweist, die auf der Vorderseite des Halbleiterkörpers (30) aufliegt und das optische Element (40) eine zweite Oberfläche aufweist, die auf dem ebenen Träger (20) aufliegt und die erste Ausformung als Kavität (42) oder als Falz (70) ausgebildet ist,
- der Halbleiterkörper (30) auf der ebenen Oberfläche des Trägers (20) angeordnet ist, wobei die Kavität (42) oder der Falz (70) größer als der Halbleiterkörper (30) ist und der Raum zwischen der Kavität (42) des optischen Elements (40) und den Seitenflächen (36) des Halbleiterkörpers (30) und der Oberfläche des Trägers (20) mit einer Vergussmasse (50) ausgefüllt ist,
- das optische Element (40) aus einer Quarzglasverbindung besteht und linsenförmig oder pyradmidenstumpfförmig ausgebildet ist.

2. Solarzellenempfänger (10) nach Anspruch 1, **dadurch gekennzeichnet, dass** die By-Pass Diode (60) auf der planaren Oberfläche des Trägers (20) in der Kavität (42) angeordnet ist.

3. Solarzellenempfänger (10) nach Anspruch 1 oder 2, **dadurch gekennzeichnet, dass** zwischen den Seitenflächen (36) und der ersten Ausformung ein Dichtmittel vorgesehen ist.

4. Solarzellenempfänger (10) nach einem der Ansprüche 1 bis 3, **dadurch gekennzeichnet, dass** zwischen der zweiten Oberfläche und dem Träger (20) eine Klebstoffschicht (52) ausgebildet ist.

5. Solarzellenempfänger (10) nach einem der Ansprüche 1 bis 4, **dadurch gekennzeichnet, dass** zwischen der ersten Oberfläche und der Vorderseite (32) des Halbleiterkörpers (30) eine Vergussmasse (50) ausgebildet ist.

6. Solarzellenempfänger (10) nach einem der Ansprüche 1 bis 5, **dadurch gekennzeichnet, dass** die Kavität (42) oder der Falz (70) der ersten Ausformung vollständig umlaufend um die Seitenflächen (36) des Halbleiterkörpers (30) ausgebildet sind.

7. Solarzellenempfänger (10) nach einem der Ansprüche 1 bis 6, **dadurch gekennzeichnet, dass** das optische Element (40) eine zweite als Kavität ausgebildete Ausformung aufweist.

8. Solarzellenempfänger (10) nach dem Anspruch 7, **dadurch gekennzeichnet, dass** die zweite Ausformung mit der ersten Ausformung der-art eine Verbindung aufweist, dass nur einen einzige Ausformung ausgebildet wird.

9. Solarzellenempfänger (10) nach einem der Ansprüche 1 bis 8, **dadurch gekennzeichnet, dass** die Vergussmasse (50) transparent ist.

10. Solarzellenempfänger (10) nach einem der vorangegangenen Ansprüche, **dadurch gekennzeichnet, dass** das optische Element (40) ein sekundäres optisches Element ist und einen bereits gebündelten Lichtstrahl weiter konzentriert.

11. Solarzellenempfänger (10) nach einem der vorangegangenen Ansprüche, **dadurch gekennzeichnet, dass** das optische Element (40) transparent für ultraviolettes Licht ist.

## Claims

1. Solar cell receiver (10) comprising
- a semiconductor body (30), having a front side (32) with a solar cell formed on the front side and a rear side (34) and several side surfaces (36) and two electrical connections,
- a carrier (20) for mounting the semiconductor body, wherein the rear side (34) of the semiconductor body (30) is fixed to the carrier (20), and
- an optical element (40) for focussing light onto the front side (32) of the semiconductor body (30), wherein the optical element (40) is of integral construction, **characterised in that**
- the entire carrier (20) has a flat surface,
- the optical element has a lower side which partly faces the upper side of the semiconductor body (30),
- the optical element has at the lower side a first shaped portion with a first surface resting on the front side of the semiconductor body (30) and the optical element (40) has a second surface resting on the flat carrier (20) and the first shaped portion is formed as a cavity (42) or as a fold (70),
- the semiconductor body (30) is arranged on the flat surface of the carrier (20), wherein the cavity (42) or the fold (70) is larger than the semiconductor body (30) and the space between the cavity (42) of the optical element (40) and the side surfaces (36) of the semiconductor body (30) and the surface of the carrier (20) is filled with a sealing compound (50), and
- the optical element (40) consist of a quartz glass composite and is formed to be lens-shaped or to have the shape of a frustum of a pyramid.

2. Solar cell receiver (10) according to claim 1, **characterised in that** the bypass diode (60) is arranged on the planar surface of the carrier (20) in the cavity (42).

3. Solar cell receiver (10) according to claim 1 or 2, **characterised in that** a sealant is provided between the side surfaces (36) and the first shaped portion.

4. Solar cell receiver (10) according to any one of claims 1 to 3, **characterised in that** an adhesive layer (52) is formed between the second surface and the carrier (20).

5. Solar cell receiver (10) according to any one of claims 1 to 4, **characterised in that** a sealing compound (50) is formed between the first surface and the front side (32) of the semiconductor body (30).

6. Solar cell receiver (10) according to any one of claims 1 to 5, **characterised in that** the cavity (42) or the fold (70) of the first shaped portion is formed to be completely encircle the side surfaces (36) of the semiconductor body (30).

7. Solar cell receiver (10) according to any one of claims 1 to 6, **characterised in that** the optical element (40) has a second shaped portion formed as a cavity.

8. Solar cell receiver (10) according to claim 7, **characterised in that** the second shaped portion has such a connection with the first shaped portion that only a single shaped portion is formed.

9. Solar cell receiver (10) according to any one of claims 1 to 8, **characterised in that** the sealing compound (50) is transparent.

10. Solar cell receiver (10) according to any one of the preceding claims, **characterised in that** the optical element (40) is a secondary optical element and further concentrates an already focussed light beam.

11. Solar cell receiver (10) according to any one of the preceding claims, **characterised in that** the optical element (40) is transparent to ultraviolet light.

## Revendications

1. Récepteur de cellule solaire (10) avec
- un corps semi-conducteur (30), présentant un côté antérieur (32) avec une cellule solaire formée sur le côté antérieur et un côté postérieur (34) et plusieurs faces latérales (36) et deux raccords électriques,
- un support (20) destiné à recevoir le corps semi-conducteur, dans lequel le côté postérieur (34) du corps semi-conducteur (30) est fixé sur le support (20), et
- un élément optique (40) pour une focalisation de lumière sur le côté antérieur (32) du corps semi-conducteur (30), dans lequel l'élément optique (40) est réalisé en une seule pièce,
**caractérisé en ce que**
- tout le support (20) présente une surface plane,
- l'élément optique présente un côté inférieur, qui est en partie tourné vers le côté supérieur du corps semi-conducteur (30),
- l'élément optique (40) présente sur le côté inférieur un premier enfoncement avec une première surface, qui s'applique sur le côté antérieur du corps semi-conducteur (30) et l'élément optique (40) présente une deuxième surface, qui s'applique sur le support plan (20) et le premier enfoncement est réalisé sous la forme d'une cavité (42) ou d'une feuillure (70),
- le corps semi-conducteur (30) est disposé sur la surface plane du support (20), dans lequel la cavité (42) ou la feuillure (70) est plus grande que le corps semi-conducteur (30) et l'espace entre la cavité (42) de l'élément optique (40) et les faces latérales (36) du corps semi-conducteur (30) et la surface du support (20) est rempli avec une masse de coulage (50),
- l'élément optique (40) se compose d'un composé en verre de quartz et est réalisé en forme de lentille ou en forme de tronc de pyramide.

2. Récepteur de cellule solaire (10) selon la revendication 1, **caractérisé en ce que** la diode de dérivation (60) est disposée sur la surface plane du support (20) dans la cavité (42).

3. Récepteur de cellule solaire (10) selon la revendication 1 ou 2, **caractérisé en ce qu'**il est prévu un moyen d'étanchéité entre les faces latérales (36) et le premier enfoncement.

4. Récepteur de cellule solaire (10) selon l'une quelconque des revendications 1 à 3, **caractérisé en ce qu'**une couche de colle (52) est formée entre la deuxième surface et le support (20).

5. Récepteur de cellule solaire (10) selon l'une quelconque des revendications 1 à 4, **caractérisé en ce qu'**une masse de coulage (50) est formée entre la première surface et le côté antérieur (32) du corps semi-conducteur (30).

6. Récepteur de cellule solaire (10) selon l'une quelconque des revendications 1 à 5, **caractérisé en ce que** la cavité (42) ou la feuillure (70) du premier enfoncement est formée de façon à entourer entièrement les faces latérales (36) du corps semi-conducteur (30).

7. Récepteur de cellule solaire (10) selon l'une quelconque des revendications 1 à 6, **caractérisé en ce que** l'élément optique (40) présente un deuxième enfoncement réalisé sous forme de cavité.

8. Récepteur de cellule solaire (10) selon la revendication 7, **caractérisé en ce que** le deuxième enfoncement présente une liaison avec le premier enfoncement, de telle manière qu'ils ne forment qu'un seul enfoncement.

9. Récepteur de cellule solaire (10) selon l'une quelconque des revendications 1 à 8, **caractérisé en ce que** la masse de coulage (50) est transparente.

10. Récepteur de cellule solaire (10) selon l'une quelconque des revendications précédentes, **caractérisé en ce que** l'élément optique (40) est un élément optique secondaire et concentre encore davantage un faisceau lumineux déjà focalisé.

11. Récepteur de cellule solaire (10) selon l'une quelconque des revendications précédentes, **caractérisé en ce que** l'élément optique (40) est transparent pour la lumière ultraviolette.
